# EUROPEAN PATENT APPLICATION

(11) **EP 3 623 355 A1**
(43) Date of publication of application: **18.03.2020**
(21) Application number: 19196737.1
(22) Date of filing: 11.09.2019
(51) Int. Cl.: C04B 41/49, C04B 41/00, C04B 41/52, C04B 41/87, C04B 41/89, C23C 16/30, C23C 16/32, C23C 16/40, C23C 28/04, F01D 5/28

(54) **COMPOSITIONAL CONTROL OF PROTECTIVE LAYERS**

(30) Priority: 11.09.2018 US 201816127993
(71) Applicant: United Technologies Corporation, Farmington, CT 06032 (US)
(72) Inventor: SCHMIDT, Wayde R., Pomfret Center, CT 06259 (US); SHEEDY, Paul, Bolton, CT 06043 (US)
(74) Representative: Dehns

(57) **Abstract**

A process for preparing a coating utilized for thermal and environmental barrier coating (10) on a substrate (12) is disclosed. The process comprises preparing a starter oxycarbide composition; and preloading a metal material in said starter oxycarbide composition.

## Description

### BACKGROUND

The disclosure relates to a process of preparing compositions for use as thermal and environmental barrier coatings for articles comprising a substrate containing silicon. The environmental barrier coating (EBC) functions as a protective environmental barrier coating and inhibits the formation of gaseous species of Si, particularly Si(OH)ₓ when the article is exposed to a high temperature, moisture-containing (water and/or steam) environment.

Ceramic materials containing silicon and metal alloys containing silicon have been proposed for structures used in high temperature applications as, for example, gas turbine engines, heat exchangers, internal combustion engines, and the like. A particularly useful application for these materials is for use in gas turbine engines which operate at high temperatures in moisture-containing environments.

It has been found that these silicon containing structures can recess and lose mass as a result of formation of volatile silicon species, particularly Si(OH)ₓ and SiO when exposed to high temperature, aqueous environments.

It is believed that the process involves oxidation of the silicon containing structure to form silica on the surface followed by reaction of the silica with steam to form volatile species of silicon such as Si(OH)ₓ. Naturally it would be highly desirable to provide an external barrier coating for silicon containing substrates which would inhibit the formation of volatile silicon species, Si(OH)ₓ and SiO, and thereby reduce recession and mass loss.

### SUMMARY

In accordance with the present disclosure, there is provided a process for preparing a coating utilized for thermal and environmental barrier coating on a substrate, the process comprising preparing an oxycarbide precursor composition; and preloading a metal species in the oxycarbide precursor composition.

In another and alternative embodiment, the metal species is selected from the group consisting of Ca, Mg, Al, B, Ba, Sr, Ti, Zr, Hf, Nb, Ta, Cr, Mo, W, Y, Yb, La, Ce, Nd, Gd, Dy, and Lu.

In another and alternative embodiment, the process further comprises uniformly doping the oxycarbide precursor composition.

In another and alternative embodiment, the process further comprises doping the oxycarbide precursor composition with predetermined cations, the predetermined cations having properties which provide a desirable interaction with a companion phase within an oxide matrix of the environmental barrier coating.

In another and alternative embodiment, the oxide matrix comprises a multi-phase mixture.

In another and alternative embodiment, the companion phases are selected from the group consisting of a SiO₂ rich phase, a self-healing phase, and a glass phase.

In another and alternative embodiment, the process further comprises doping the oxycarbide precursor composition with predetermined cations, the predetermined cations having properties which provide a desirable interaction with phases external to the environmental barrier coating.

In another and alternative embodiment, the external phases comprise a calcium magnesium alumino silicate (CMAS) material.

In another and alternative embodiment, the oxycarbide is doped with predetermined cations comprising one or more of calcium, magnesium, aluminum, or iron to reduce chemical interactions with the external CMAS material.

In another and alternative embodiment, the oxycarbide is doped with predetermined cations comprising one or more of aluminum, titanium, hafnium, or zirconium which induces crystallization in the external CMAS material.

In another and alternative embodiment, the process further comprises reacting the oxycarbide precursor composition to form the environmental barrier coating.

In another and alternative embodiment, the reacting of the oxycarbide precursor comprises pyrolyzing.

In another and alternative embodiment, the environmental barrier coating is formed in part or in full.

In another and alternative embodiment, the process further comprises utilizing the oxycarbide precursor composition in at least one of as an entire composition of the coating and as an additive in the coating.

Other details of the coating are set forth in the following detailed description and the accompanying drawings wherein like reference numerals depict like elements.

### BRIEF DESCRIPTION OF THE DRAWINGS

FIG. 1 is a cross section of an exemplary coating on a substrate containing silicon according to the disclosure.
FIG. 2 is a cross section of an exemplary coating on a substrate containing silicon according to the disclosure.
FIG. 3 is an illustration of an exemplary compositional gradient for the M species and lack thereof.

### DETAILED DESCRIPTION

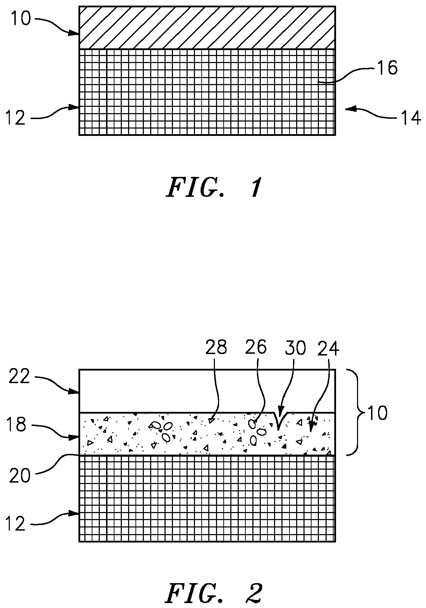

Referring now to FIG. 1, there is illustrated an environmental barrier coating 10 formed over a substrate 12 of an article 14, configured to inhibit the formation of gaseous species of silicon when the article 14 is exposed to a high temperature, moisture-containing environment. The substrate 12 can be associated with articles 14 such as, at least one of a turbine vane and a turbine blade, and particularly a gas turbine engine component, such as components in the hot section of the gas turbine engine, including static and rotating components and portions of combustors, and the like.

The substrate 12 can be constructed from materials containing silicon and can be a ceramic matrix composite material, a monolithic ceramic, a silicon-based or silicon containing ceramic substrate or a silicon containing metal alloy. In an exemplary embodiment, the substrate 12 can be silicon containing ceramic material such as, for example, silicon carbide, silicon nitride, silicon carbide/aluminum nitride, silicon oxy-nitride and silicon aluminum oxy-nitride, alkaline earth or rare earth silicate glasses or glass ceramics and combinations thereof. Examples can include barium alumino silicate (BAS), barium strontium alumino silicate (BSAS), strontium alumino silicate (SAS), lithium alumino silicate (LAS), aluminosilicate (AS), mullite, yttrium silicate, ytterbium silicate, and the like. In accordance with a particular embodiment, the silicon containing ceramic substrate comprises a silicon containing matrix with reinforcing materials 16 such as fibers, particles and the like and, more particularly, a silicon based matrix which is fiber-reinforced. Particularly suitable ceramic substrates are a silicon carbide fiber-reinforced silicon carbide matrix, a carbon fiber-reinforced silicon carbide matrix and a silicon carbide fiber-reinforced silicon nitride matrix. Particularly useful silicon-metal alloys for use as substrates for the article 14 can include molybdenum-silicon alloys, niobium-silicon alloys, iron-silicon alloys, and alloys of zirconium, hafnium, titanium, chromium, tungsten, boron, platinum, and tantalum.

Referring also to FIG. 2, an environmental barrier layer 18 can be applied to the substrate 12 on a surface 20. In some embodiments, a protective layer 22 can be applied on the environmental barrier layer 18. The protective layer 22 is configured to resist recession of the Si-containing volatile species when exposed to water vapor or steam. In an exemplary embodiment, the protective layer 22 can include binary or multicomponent oxides such as HfO₂, ZrO₂, Gd₂Hf₂O₇, Gd₂Zr₂O₇ , and refractory metal oxides. In other exemplary embodiments, the protective layer 22 can include silicates with low(er) SiO₂ activities. In another exemplary embodiment the protective layer 22 can include (rare earth) RE-monosilicates, disilicates and (alkaline earth) AE alumino silicates, and silicates of hafnium and zirconium.

In an exemplary embodiment, environmental barrier layer 18 can comprise a silicon oxycarbide-based composition that has Si, O, and C atoms in a covalently bonded network. In an exemplary embodiment, the network is generally amorphous or noncrystalline and thus does not have long range crystalline structure. The network is merely one example in which at least a portion of the silicon atoms are bonded to both O atoms and C atoms. As can be appreciated, the bonding of the network will vary depending upon the atomic ratios of the Si, C, and O. In one example, the covalently bonded network is semicrystalline or turbostratic. In one example, the silicon oxycarbide-based environmental barrier layer 18 has a composition SiOₓM_{z}C_{y}, where M is at least one metal, x is less than two, y is greater than zero, z is less than one, and x and z are non-zero. The metal can include aluminum, boron, transition metals, refractory metals, rare earth metals, alkaline earth metals or combinations thereof. In one example, the silicon oxycarbide-based environmental barrier layer 18 is derived from one or more precursors with an appropriate chemical composition to form the SiOₓM_{z}C_{y}.

The environmental barrier layer 18 can further include an oxide matrix 24 and an oxygen gettering phase 26 interspersed throughout the oxide matrix 24. The oxide matrix 24 can include a multi-phase mixture with companion phase(s), such as SiO₂ rich phases and a self-healing phase 28 that can include a glass phase or a metallic phase or both.

In an exemplary embodiment, the composition of the oxide matrix 24 dictates the mole fraction of the glass and the SiO₂. The self-healing phase 28 can include a material having properties that are in thermodynamic equilibrium with SiO₂ during operation at predetermined temperatures. The self-healing phase 28 comprises a material having properties of flowing into cracks 30 formed in the matrix 24 during operation at those predetermined temperatures. The self-healing phase 28 can be sufficiently fluid at high temperatures to flow into the cracks 30 in the coating 10, which imparts a self-healing functionality. In an exemplary embodiment, the self-healing phase 28 can include doped silicates, compatible metals/metal alloys, non-oxide glasses, the SiO₂ itself, as well as any representative glass/glass ceramics such as BAS, BMAS, LAS, SAS.

In an exemplary embodiment the oxygen gettering phase can comprise silicon oxycarbide, SiₓO_{y}Cz where x is greater than or equal to 0.5 and x is less than 1; y is greater than 0 and y is less than 2; and z is greater than or equal to 0 and z is less than 2.

The environmental barrier layer 18 can be present on the substrate 12 at a thickness of greater than or equal to about 0.5 mils (0.0005 inch), preferably between about 3 to about 30 mils and ideally between about 3 to about 5 mils (12.5 microns, 75-750 microns, 75-125 microns, respectively).

The disclosure contemplates the incorporation of metal in the starting oxycarbide and its precursor(s) in order to control its stability including resistance to decomposition or the migration/incorporation of metallic species from other constituents formulated within the coating, from calcium magnesium alumino silicate (CMAS) attack, or from other externally delivered phases or particulates.

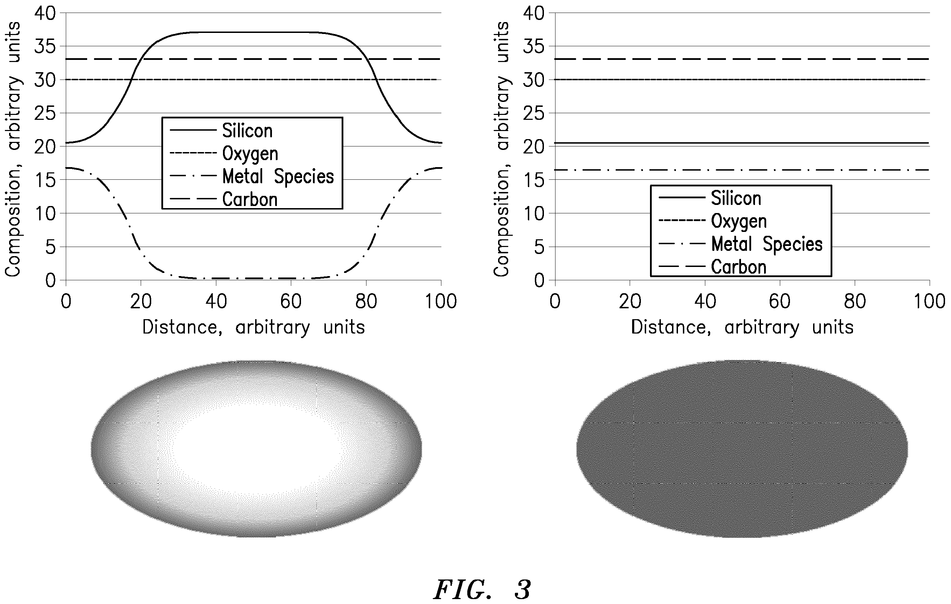

The oxycarbide precursor could be doped with Ca, Mg, Al, etc. to potentially provide for enhanced stability against CMAS. In an exemplary embodiment, the oxycarbide precursor is uniformly doped. Conversely, the oxycarbide could be doped with other cations which may provide a desirable interaction with the companion or externally delivered phase(s), such as perhaps Ti and/or Al-doping, which for example may elicit crystallization of CMAS. A precise control over the dopant composition in the oxycarbide is desired and may encompass even levels beyond simply 'doping', up to several atomic %. Referring to Fig. 3, that illustrates a compositional gradient for the M species and lack thereof. The oxycarbide of the in previously utilized compositions contains diffusional gradients of the 'doped' metal, M, species. Whereas in the current exemplary embodiment, the oxycarbide exhibits a uniform composition. The uniform composition reduces the driving force for diffusion of metal cation species, M, from sources external to the oxycarbide into the oxycarbide. It should be understood that for multi-cation doping, M is shown schematically as an aggregate of all metal species which may be doped in the oxycarbide. In past applications, multiple cation species may diffuse into the coating differently from each other (i.e. for 'CMAS' the calcium may diffuse in more readily than the magnesium or aluminum).

Precursor(s) suitable for forming the silicon oxycarbide-based layer include sol-gel precursors, preceramic polymers, including silicon-based inorganic polymers and carbon-based resins, as well as particulate filled mixtures of such materials and chemically modified derivatives of these materials having metallic species. Exemplary sol-gel precursors include alkyl- and alkoxy-based silanes or other alkyl- and alkoxy-functionalized metal species. Exemplary preceramic polymers include polycarbosilanes, polycarbosiloxanes, polysilazanes, and metal-containing derivatives of such polymers. Examples can be found in the following references U.S. patents 8,710,169; 9,169,163 and 9,745,226. Mixtures of such precursors and metal-containing species which can be homogeneously dispersed within these precursors are also contemplated. Suitable dopants including metal species based on Ca, Mg, Al, B, Ba, Sr, Ti, Zr, Hf, Nb, Ta, Cr, Mo, W, Y, Yb, La, Ce, Nd, Gd, Dy, and Lu.. In one example, a preceramic polymer containing aluminum is deposited onto the silicon-based substrate and subjected to external radiation sufficient to convert the preceramic polymer to the desired silicon oxycarbide-based layer. Suitable deposition methods of neat liquids include dipping, spraying, painting, and the like. If the precursors are solids, appropriate solvents can be selected to create flowable liquids and the coatings can be fabricated using similar methods and additional methods known in the art. Exemplary radiation includes heat, microwave, ultrasonic, electron beam, plasma and the like.

The environmental barrier layer 18 can be applied by preparing a surface 20 of the substrate 12. The environmental barrier layer 18 can be applied to the substrate 12 by use of slurry based methods including dip or spray coating, painting, or electrophoretic deposition and the like. In alternative embodiments, the environmental barrier layer 18 can be applied by vapor deposition, including, atomic layer deposition, chemical vapor deposition, and electron-beam physical vapor deposition, or thermal spray, including air plasma spray, suspension plasma spray, low pressure or vacuum plasma spray, high velocity oxygen or air fuel spraying, and flame spraying. Coatings can be applied manually or using automation equipment such as robotics. The oxycarbide precursor composition can be utilized as an entire composition of the coating or as an additive in the coating.

In an exemplary embodiment, the oxycarbide precursor composition can be reacted to form the environmental barrier coating 10. A pyrolyzing process can be utilized in the reaction to form the environmental barrier coating 10. The environmental barrier coating can be formed in part or in full.

A technical advantage of the process can include a potential to reduce loading of metal-containing fillers in coatings by incorporating the metal directly in the oxycarbide structure, for example via chemical bonding.

Another technical advantage of the process can include an increase in coating stability due to reduced migration of metal species into the oxycarbide from the added constituents.

Another technical advantage of the process can include an enhanced resistance to CMAS and other corrosive silicates and salts/ions by initial incorporation of the appropriate metal ions into the oxycarbide.

An advantage of utilizing the disclosed environmental barrier coating 10 is that the coating composition offers a robust composition for protecting components in the hot-section of gas turbine engines. In some embodiments the disclosed compositions can form a multiphase matrix that consists of a liquid phase and silica at elevated temperatures. The compositions can be varied to create coatings with different properties for a desired application.

The advantages of the disclosed process can benefit ceramic matrix composite (CMC) materials which can be advantageous for the high temperature operating capabilities of aero components. Additionally, the coatings described herein on the CMC components can protect the components from engine operating conditions and/or exposure to environmental conditions. For example, an environmental barrier coating can protect CMC components from oxidation by preventing or minimizing oxygen ingress to the CMC component while an abradable coating can promote sealing.

There has been provided a process of preparing compositions. While the process has been described in the context of specific embodiments thereof, other unforeseen alternatives, modifications, and variations may become apparent to those skilled in the art having read the foregoing description. Accordingly, it is intended to embrace those alternatives, modifications, and variations which fall within the broad scope of the appended claims.

## Claims

1. A process for preparing a coating utilized for thermal and environmental barrier coating (10) on a substrate (12), the process comprising:
preparing an oxycarbide precursor composition; and
preloading a metal species in said oxycarbide precursor composition.

2. The process of claim 1 wherein said metal species is selected from the group consisting of Ca, Mg, Al, B, Ba, Sr, Ti, Zr, Hf, Nb, Ta, Cr, Mo, W, Y, Yb, La, Ce, Nd, Gd, Dy, and Lu.

3. The process of claim 1 or 2, further comprising:
uniformly doping said oxycarbide precursor composition.

4. The process of claim 1, 2 or 3, further comprising;
doping said oxycarbide precursor composition with predetermined cations, said predetermined cations having properties which provide a desirable interaction with a companion phase within an oxide matrix of said environmental barrier coating (10).

5. The process of claim 4, wherein said oxide matrix comprises a multi-phase mixture.

6. The process of claim 4 or 5, wherein said companion phases are selected from the group consisting of a SiO₂ rich phase, a self-healing phase, and a glass phase.

7. The process of any preceding claim, further comprising;
doping said oxycarbide precursor composition with predetermined cations, said predetermined cations having properties which provide a desirable interaction with phases external to said environmental barrier coating (10).

8. The process of claim 7, wherein said external phases comprise a calcium magnesium alumino silicate (CMAS) material.

9. The process of claim 8, wherein said oxycarbide is doped with predetermined cations comprising one or more of calcium, magnesium, aluminum, or iron to reduce chemical interactions with said external CMAS material.

10. The process of claim 8, wherein said oxycarbide is doped with predetermined cations comprising one or more of aluminum, titanium, hafnium, or zirconium which induces crystallization in said external CMAS material.

11. The process of any preceding claim, further comprising:
reacting said oxycarbide precursor composition to form said environmental barrier coating (10).

12. The process of claim 11, wherein said reacting of said oxycarbide precursor comprises pyrolyzing.

13. The process of claim 11 or 12, wherein said environmental barrier coating (10) is formed in part or in full.

14. The process of any preceding claim, further comprising:
utilizing said oxycarbide precursor composition in at least one of as an entire composition of the coating and as an additive in the coating (10).
